# EUROPÄISCHE PATENTANMELDUNG

(11) **EP 0 789 245 A2**
(43) Veröffentlichungstag der Anmeldung: **13.08.1997**
(21) Anmeldenummer: 97810063.4
(22) Anmeldetag: 04.02.1997
(51) Int. Cl.: G01R 15/24

(54) **Spannungsmesseinrichtung**

(30) Priorität: 10.02.1996 DE 19604908
(71) Anmelder: ABB RESEARCH LTD., 8050 Zürich (CH)
(72) Erfinder: Bohnert, Klaus, Dr., 5443 Niederrohrdorf (CH); Hartmann, Hans, 8106 Adlikon (CH); Ingold, Mathias, Dr., 8165 Unterengstringen (CH); Jost, Alfred, 8165 Schöfflisdorf (CH); Kostovic, Jadran, 5432 Neuenhof (CH)
(74) Vertreter: Kaiser, Helmut, Dr.

(57) **Zusammenfassung**

Die Messeinrichtung ist für den Einsatz in isoliergasgefüllten, metallgekapselten gasisolierten Schaltanlagen vorgesehen. Sie weist mindestens einen mit einer optischen Glasfaser versehenen, entlang einer zentralen Achse (25) erstreckten Quarzkörper (34) als Sensor auf.

Es soll eine faseroptische Messeinrichtung geschaffen werden, die in ein vergleichsweise einfach ausgebildetes, kompaktes und kostengünstiges Gefäss eingebaut ist. Dies wird dadurch erreicht, dass der Sensor in einem separaten Volumen (40) im Innern der Schaltanlage angeordnet ist, welches von einem unteren Endflansch (28) und einem oberen Endflansch (30) und einem mit diesen druckdicht verbundenen Isolierrohr (29) begrenzt wird, dass der untere Endflansch (28) elektrisch leitend mit einem mit Hochspannung beaufschlagten Aktivteil (22) der Schaltanlage und mit der unteren Stirnseite des Quarzkörpers verbunden ist, und dass der obere Endflansch (30) elektrisch leitend mit der geerdeten Kapselung (21) der Schaltanlage und mit der oberen Stirnseite des Quarzkörpers verbunden ist.

## Beschreibung

### TECHNISCHES GEBIET

Die Erfindung geht aus von einer Messeinrichtung gemäss dem Oberbegriff des Patentanspruchs 1.

### STAND DER TECHNIK

Aus der Veröffentlichung von K. Bohnert und J. Nehring in der Zeitschrift Applied Optics, Vol. 27 (1988), S.4814-4818, ist eine faseroptische Spannungsmesseinrichtung mit einem faseroptischen Spannungssensor bekannt. Der faseroptische Spannungssensor weist einen kreiszylindrisch ausgebildeten, piezoelektrisch wirksamen Quarz auf, der mit einer seiner Hauptachsen beispielsweise vertikal ausgerichtet ist. Der Quarz ist mit einer auf seinem Zylinderumfang enganliegenden optischen Faser gleichmässig bewickelt.

Im elektrischen Feld erfährt ein Quarzzylinder eine Umfangsänderung, welche über die resultierende Längenänderung der optischen Faser interferometrisch gemessen wird. Eine durch mechanische Erschütterungen hervorgerufene Deformation des Quarzzylinders ist unerwünscht, da sie zu einer fehlerhaften Änderung der Länge der optischen Faser führen kann.

Insbesondere bei Spannungsmesseinrichtungen, die für Schutzzwecke eingesetzt werden, können schwingungsbedingte Fehlanzeigen und dadurch eventuell verursachte Fehlauslösungen des Schutzes nicht toleriert werden. Mechanische Kräfte parallel zur Quarzzylinderachse einer solchen Spannungsmesseinrichtung bewirken über die Poisson'sche Querdehnung des Quarzzylinders eine Dehnung der aufgewickelten optischen Faser, die schlussendlich ein Störsignal verursacht.

Für den direkten Einbau in metallgekapselte, mit SF₆-Gas isolierte Schaltanlagen ist diese Spannungsmesseinrichtung nicht oder nur bedingt geeignet, da die im Innern der metallgekapselten gasisolierten Schaltanlagen zumindest zeitweise vorhandenen Zersetzungsprodukte des SF₆-Gases den Quarzzylinder und auch die um ihn gewickelte optische Faser angreifen würden. Die Spannungsmesseinrichtung wird deshalb in der Regel in ein separates, mit SF₆-Gas gefülltes Gefäss eingebaut. Das SF₆-Gas muss in dieses Gefäss eingefüllt werden, was einen separaten Gasanschluss bedingt, zudem muss der Gasdruck in diesem Gefäss mittels eines Druckwächters überwacht werden, und für den Fall eines Störlichtbogens muss dieses Gefäss mit einer Berstscheibe versehen sein, welche im Notfall, d.h. beim Auftreten eines Lichtbogens in diesem Gefäss, eine Druckentlastung ermöglicht. Durch diese zusätzlichen Baugruppen wird das Gefäss vergrössert und damit auch verteuert.

### DARSTELLUNG DER ERFINDUNG

Die Erfindung, wie sie im unabhängigen Anspruch 1 gekennzeichnet ist, löst die Aufgabe, eine faseroptische Messeinrichtung zu schaffen, die in ein vergleichsweise einfach ausgebildetes, kompaktes und kostengünstiges Gefäss eingebaut ist.

Die Messeinrichtung ist für den Einsatz in isoliergasgefüllten, metallgekapselten gasisolierten Schaltanlagen vorgesehen. Sie weist mindestens einen mit einer optischen Glasfaser eng umwickelten, entlang einer zentralen Achse erstreckten Quarzkörper als Sensor auf. Der Sensor ist in einem separaten Volumen im Innern der Schaltanlage angeordnet, welches von einem unteren Endflansch, einem oberen Endflansch und einem mit diesen beiden Flanschen druckdicht verbundenen Isolierrohr begrenzt wird. Der untere Endflansch ist elektrisch leitend mit einem mit Hochspannung beaufschlagten Aktivteil der Schaltanlage und mit der unteren Stirnseite des Quarzkörpers verbunden. Der obere Endflansch ist elektrisch leitend mit der geerdeten Kapselung der Schaltanlage und mit der oberen Stirnseite des Quarzkörpers verbunden. Der Sensor überbrückt die Potentialdifferenz zwischen dem Aktivteil und der Kapselung der metallgekapselten gasisolierten Schaltanlage.

Die durch die Erfindung erreichten Vorteile sind im wesentlichen darin zu sehen, dass die Messeinrichtung sehr kompakt aufgebaut ist. Die Messeinrichtung kann vergleichsweise einfach vor den Zersetzungsprodukten des SF₆-Gases geschützt werden. Ein separater Gasanschluss, ein Druckwächter und eine Berstscheibe können bei der vorliegenden Messeinrichtung eingespart werden. Beim Auftreten eines Lichtbogens in dieser Messeinrichtung erfolgt die nötige Druckentlastung in einen benachbarten mit SF₆-Gas gefüllten Gasraum, der bereits mit einer Berstscheibe versehen ist. Darüberhinaus reduziert die erfindungsgemässe, kompakt aufgebaute Messeinrichtung in vorteilhafter Weise das für das Aufstellen der metallgekapselten gasisolierten Schaltanlage benötigte Bauvolumen, da ihr oberer Endflansch samt Deckel nur unwesentlich über die Kapselung der Schaltanlage hinausragt. Insbesondere bei mehrphasig metallgekapselten gasisolierten Schaltanlagen wirkt sich die kompakte Bauweise dieser Messeinrichtung vorteilhaft aus.

Als besonders vorteilhaft erweist es sich, dass der Sensor einen Quarzzylinder aufweist, welcher an der oberen Stirnseite mit einer ersten allseitig stoss- und schwingungsgedämpft gelagerten metallischen Halterung versehen ist und welcher an der unteren Stirnseite mit einer zweiten allseitig stoss- und schwingungsgedämpft gelagerten metallischen Halterung versehen ist.

Weitere Ausgestaltungen der Erfindung sind Gegenstände der abhängigen Ansprüche.

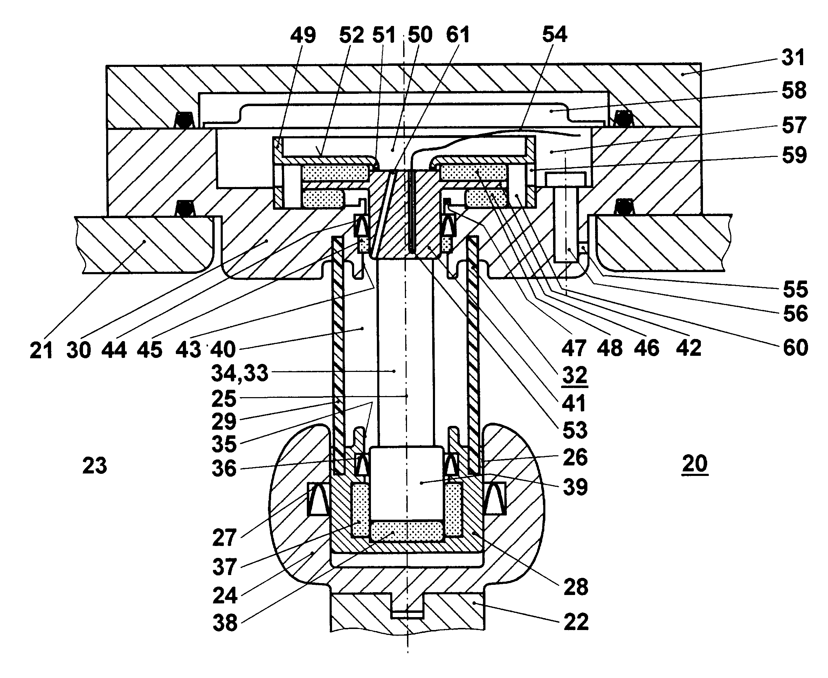

Die Erfindung, ihre Weiterbildung und die damit erzielbaren Vorteile werden nachstehend anhand der Zeichnung, welche lediglich einen möglichen Ausführungsweg darstellt, näher erläutert.

### KURZE BESCHREIBUNG DER ZEICHNUNG

Die Figur zeigt eine Prinzipskizze einer Ausführungsform einer erfindungsgemässen Messeinrichtung.

Alle für das unmittelbare Verständnis der Erfindung nicht erforderlichen Elemente sind in der Figur nicht dargestellt.

### WEGE ZUR AUSFÜHRUNG DER ERFINDUNG

Die Figur zeigt eine Prinzipskizze einer vorteilhaften Ausführungsform einer erfindungsgemässen faseroptischen Messeinrichtung. Diese Messeinrichtung ist hier als eine Spannungsmesseinrichtung 20 ausgebildet. Diese Spannungsmesseinrichtung 20 ist in eine metallgekapselte gasisolierte Schaltanlage eingebaut, von der lediglich ein Teil der in der Regel geerdeten Kapselung 21 und ein Teil eines spannungsbeaufschlagten Aktivteils 22 schematisch dargestellt ist. Die Kapselung 21 und nicht dargestellte Schottungsisolatoren schliessen ein mit SF₆-Gas unter Druck gefülltes Volumen 23 ein. An dem Aktivteil 22 ist eine dielektrisch günstig ausgebildete metallische Schirmelektrode 24 befestigt. Die Schirmelektrode 24 ist zylindrisch ausgebildet, sie weist eine zentrale Achse 25 auf. Diese zentrale Achse 25 ist gleichzeitig die zentrale Achse der zylindrisch ausgebildeten Spannungsmesseinrichtung 20.

Die Schirmelektrode 24 weist auf der dem Aktivteil 22 abgewandten Seite eine zentrale Bohrung 26 auf. In die Wand der Bohrung 26 ist eine Nut eingelassen, in welcher ein Ring von Kontaktfedern 27, beispielsweise aus Beryllium-Kupfer, gehalten ist. Die Bohrung 26 nimmt einen unteren Endflansch 28 der Spannungsmesseinrichtung 20 auf. Der untere Endflansch 28 besteht aus Metall, er wird durch die Kontaktfedern 27 in der Bohrung 26 zentriert und elektrisch leitend mit dem Aktivteil 22 verbunden. Zwischen dem unteren Endflansch 28 und dem Boden der Bohrung 26 verbleibt stets ein hinreichend grosses Spiel, ebenso zwischen dem unteren Endflansch 28 und der Wand der Bohrung 26.

Der untere Endflansch 28, ein in ihn druckdicht eingelassenes Isolierrohr 29, ein mit dem Isolierrohr 29 druckdicht verbundener oberer Endflansch 30 und ein den oberen Endflansch 30 auf der dem Isolierrohr 29 abgewandten Seite druckdicht verschliessender Deckel 31 bilden ein Gefäss 32 für die Aufnahme des faseroptischen Sensors 33. Der faseroptische Sensor 33 weist einen Quarzzylinder 34 auf, der entlang der zentralen Achse 25 erstreckt ist. Der Quarzzylinder 34 ist gleichmässig mit einer nicht dargestellten optischen Glasfaser bifilar umwickelt. Die beiden Enden der Glasfaser werden mittels druckdichten Durchführungen durch den oberen, auf Erdpotential liegenden Endflansch 30 oder den Deckel 31 aus dem Gefäss 32 herausgeführt und in eine nicht dargestellte Auswerteeinheit weitergeführt.

Der untere Endflansch 28 weist auf der dem Isolierrohr 29 zugewandten Seite eine zentrale Bohrung 35 auf. In die Wand der Bohrung 35 ist eine Nut eingelassen, in welcher ein Ring von Kontaktfedern 36, beispielsweise aus Beryllium-Kupfer, gehalten ist. In eine zweite, in die Wand der Bohrung 35 eingearbeitete Nut ist ein Ring 37 aus einem stoss- und schwingungsdämpfenden Material eingelegt. Der Boden der Bohrung 35 ist mit einer zylindrisch ausgebildeten Scheibe 38 aus einem stoss- und schwingungsdämpfenden Material belegt. Auf der Scheibe 38 liegt eine metallische Halterung 39 auf, die mit der unteren Stirnseite des Quarzzylinders 34 verklebt ist. Die metallische Halterung 39 wird durch die Kontaktfedern 36 und den Ring 37 in der Bohrung 35 zentriert. Die metallische Halterung 39 ist damit stoss- und schwingungsgedämpft gelagert, neben den axial nach unten wirkenden Komponenten der Schwingungen werden auch die hier gegebenenfalls auftretenden radialen Schwingungskomponenten wirkungsvoll abgedämpft. Die Kontaktfedern 36 verbinden die metallische Halterung 39 elektrisch leitend mit dem unteren Endflansch 28. Die Oberfläche des unteren Endflanschs 28 ist an der hier nach oben gerichteten Seite dielektrisch günstig ausgebildet.

Der Quarzzylinder 34 ist von einem Volumen 40 umgeben, welches mit SF₆-Gas unter Druck gefüllt ist, und zwar herrscht hier der gleiche Druck wie im Volumen 23, da diese beiden Volumina 40,23 miteinander in Wirkverbindung stehen. Die obere Stirnseite des Quarzzylinders 34 ist mit einer metallischen Halterung 41 verklebt. Die Halterung 41 ist zylindrisch ausgebildet. An die Halterung 41 ist ein tellerförmiger Bund 42 angeformt, welcher mit einer nicht dargestellten Verdrehsicherung versehen ist. Im Bereich unterhalb des Bundes 42 ist die Halterung 41 mit Spiel in einer zentralen Bohrung 43 des oberen Endflanschs 30 geführt. In die Wand der Bohrung 43 ist eine Nut eingelassen, in welcher ein Ring von Kontaktfedern 44, beispielsweise aus Beryllium-Kupfer, gehalten ist. Die Halterung 41 wird durch die Kontaktfedern 44 in der Bohrung 43 zentriert und elektrisch leitend mit dem oberen Endflansch 30 verbunden. In eine zweite, in die Wand der Bohrung 43 eingearbeitete Nut ist ein Ring 45 aus einem stoss- und schwingungsdämpfenden Material eingelegt, welcher ebenfalls zentrierend auf die Halterung 41 einwirkt. Durch diese Anordnung werden die radialen Komponenten der auf die Halterung 41 einwirkenden Schwingungen wirkungsvoll abgedämpft.

Die Oberfläche des oberen Endflanschs 30 ist an der hier nach unten gerichteten Seite dielektrisch günstig ausgebildet. Auf der Oberseite des oberen Endflanschs 30 liegt, konzentrisch zur zentralen Achse 25 positioniert, ein Ring 46 aus einem stoss- und schwingungsdämpfenden Material auf. Ferner ragt über die Oberseite des oberen Endflanschs 30 ein Anschlag 47 heraus, der gegebenenfalls mit dem Bund 42 zusammenwirkt. Auf dem Ring 46 liegt der Bund 42 auf. Auf der dem Ring 46 abgewandten Seite des Bundes 42 liegt ein weiterer, konzentrisch zur zentralen Achse 25 positionierter Ring 48 aus einem stoss- und schwingungsdämpfenden Material auf. Der Ring 48 wird durch eine mit dem oberen Endflansch 30 starr verbundene, konzentrisch zur zentralen Achse 25 angeordnete Halteeinrichtung 49 gegen den Bund 42 gedrückt. Diese Anordnung von stoss- und schwingungsdämpfendem Material dämpft die auf die metallische Halterung 41 einwirkenden axial nach oben und nach unten wirkenden Komponenten der Schwingungen ab. Der faseroptische Sensor 33 ist damit sehr wirksam allseitig stoss- und schwingungsgedämpft gelagert. Die Halteeinrichtung 49 weist eine zentrale Bohrung 50 auf. Der Rand dieser Bohrung 50 ist als gegebenenfalls mit der Halterung 41 zusammenwirkender Anschlag 51 ausgebildet. Die Halteeinrichtung 49 weist an der Oberseite eine tellerförmig ausgebildete Auflagefläche 52 auf, die vorgesehen ist für die Lagerung der Endstücke der vom faseroptischen Sensor 33 durch die Halterung 41 durchgeführten, hier nicht dargestellten, optischen Glasfasern und die Spleissstellen dieser Glasfasern mit den aus dem Gefäss 32 herausführenden Glasfasern. Wenn diese lageunabhängig einbaubare Spannungsmesseinrichtung 20 beispielsweise in einer um 180 Grad verdrehten Position eingebaut wird, so müssen diese Endstücke der Glasfasern und die Spleissstellen auf der Auflagefläche 52 befestigt werden.

Die interferometrische Detektion der durch den Quarzzylinder 34 hervorgerufenen optischen Phasenmodulation in der optischen Glasfaser erfordert eine gewisse Mindestlänge der Glasfaser. Mit der Länge der auf den Quarzzylinder 34 aufgewickelten optischen Glasfaser kann auch der gewünschte Pegel des optischen Signals eingestellt werden. Der nicht aufgewickelte Teil der Glasfaser, in diesem Fall die jeweiligen Zuleitungen zu den Spleissstellen, ruht ebenfalls auf der Auflagefläche 52.

In die Halterung 41 ist ein Thermoelement 53 eingebaut, welches die Temperatur möglichst nahe an der oberen Stirnfläche des Quarzzylinders 34 misst. Das Thermoelement 53 weist Anschlüsse 54 auf, welche druckdicht aus dem Gefäss 32 herausgeführt sind. Die Messwerte, welche das Thermoelement 53 liefert, werden zur Temperaturkompensation der durch den faseroptischen Sensor 33 ermittelten Messdaten verwendet.

An einer dielektrisch nicht kritischen Stelle ist der obere Endflansch 30 mit einer Bohrung 55 versehen. Die Bohrung 55 mündet in eine Patrone 56 ein, die auf bekannte Weise mit Molekularsiebmaterial gefüllt ist. Durch die Bohrung 55 und die Patrone 56 kann SF₆-Gas aus dem Volumen 40 in ein Volumen 57 einströmen, welches vom oberen Endflansch 30 und dem Deckel 31 eingeschlossen wird. In dem Volumen 57 ist ein Molekularsiebmaterialdepot 58 vorhanden, welches zwischen gasdurchlässigen Materialien gehalten ist. In die Halteeinrichtung 49 ist ein Durchlass 59 eingearbeitet, der das Volumen 57 mit einem Volumen 60 verbindet. Vom Volumen 60 aus kann das SF₆-Gas durch das stoss- und schwingungsdämpfenden Material des Rings 46 hindurch in die Bohrung 43 des oberen Endflanschs 30 strömen. Es strömt dabei an den Kontaktfedern 44 vorbei und weiter durch den Ring 45 aus elektrisch isolierendem, stossdämpfendem Material in das Volumen 40. Parallel zu diesem beschriebenen Strömungsweg kann das SF₆-Gas auch durch eine die Halterung 41 durchdringende Bohrung 61 vom Volumen 57 direkt in das Volumen 40 gelangen. Die Bohrung 61 dient zudem als Zu- und Abgangsöffnung für die beiden überstehenden Enden der optischen Glasfaser des Sensors. Diese Gasströmung tritt beim Füllen des Volumens 23 der metallgekapselten gasisolierten Schaltanlage mit sauberem SF₆-Gas auf, sobald ein Druckausgleich zwischen den beiden Volumina 23 und 40 erreicht ist, hört diese Strömung auf. Um die Gasströmung zu verbessern, ist es auch möglich, parallel zueinander zwei oder mehrere mit Molekularsiebmaterial bestückte Patronen 56 vorzusehen.

Die Ringe 37,45,46 und 48 sind, ebenso wie die Scheibe 38, aus einem federnden polymerischen Elastomer gefertigt, welches ein vergleichsweise grosses Zeitstandvermögen aufweist. Als besonders geeignet hat sich ein Silikonschaumstoff der Firma Rogers Corporation, PORON Materials Division, Box 158, East Woodstock, Connecticut 0621, erwiesen, der unter der Bezeichnung PORON S2000 Silicone vertrieben wird. Der Name PORON ist ein eingetragenes Warenzeichen der obigen Firma. Dieser Silikonschaumstoff hat besonders gute stoss- und schwingungsdämpfende Eigenschaften. Er besitzt eine offene Porenstruktur und weist eine besonders geringe Ausgasung von eventuell verbleibenden Restgasen auf, sodass von daher keine nennenswerten Verunreinigungen in das Innere der Messeinrichtung gelangen.

Die Ringe 37,45,46 und 48 könnten, ebenso wie die Scheibe 38 auch aus anderen stoss- und schwingungsdämpfenden Materialien gefertigt werden. Beispielsweise wäre es auch möglich, sie aus einem elektrisch leitenden Material herzustellen, sodass die Kontaktfedern 36 und 44 eingespart werden könnten.

Als Molekularsiebmaterial, welches insbesondere Zersetzungsprodukte des SF₆-Gases und Feuchtigkeit bindet, wird ein Alkali-Aluminium-Silikat mit CaO kombiniert eingesetzt. Die chemische Formel für dieses Molekularsiebmaterial ist: 0,7CaO·0,3Na₂O·Al₂O₃·2SiO₂·nH₂O. Der Hersteller dieses Molekularsiebmaterials ist die Chemische Fabrik Uetikon, 8707 Uetikon / Schweiz, besonders bewährt hat sich das Molekularsiebmaterial des Typs 5A-8/2.

Herkömmliche Spannungswandler haben einen mehrfach grösseren Platzbedarf als die vorliegende, als Modul ausgebildete Spannungsmesseinrichtung 20, sodass sie in der Regel in einem grossvolumigen separaten und vergleichsweise sehr schweren, an die metallgekapselte gasisolierte Schaltanlage angeflanschten Gehäuse untergebracht sind. Die vorliegende, als kompaktes Modul ausgebildete Spannungsmesseinrichtung 20 reduziert in vorteilhafter Weise das für das Aufstellen der metallgekapselten gasisolierten Schaltanlage benötigte Bauvolumen, da ihr oberer Endflansch 30 samt Deckel 31 nur unwesentlich über die Kapselung 21 hinausragt. Zudem können ihre Abmessungen vorteilhaft klein gehalten werden, da weder Platz für einen separaten Gasanschluss noch für eine separate Berstscheibe, die im Fehlerfall das Volumen 40 entlasten müsste, vorgesehen werden muss. Das Volumen 40 ist direkt mit dem Volumen 23 verbunden, es muss deshalb weder mit einer separaten Berstscheibe noch mit einem separaten Gasanschluss samt Drucküberwachung versehen werden.

Die Spannungsmesseinrichtung 20 kann an beliebigen Stellen in der metallgekapselten gasisolierten Schaltanlage eingebaut werden, also auch im Bereich von Leistungsschaltern, wo in dem Volumen 23 Zersetzungsprodukte des SF₆-Gases auftreten können. Beim während des Betriebs der Anlage stets stattfindenden Austausch von SF₆-Gas können vergleichsweise geringe Mengen dieser Zersetzungsprodukte in die mit Molekularsiebmaterial gefüllte, als dynamischer Filter dienende Patrone 56 fliessen, wo sie in der Regel ausgefiltert und durch das Molekularsiebmaterial unschädlich gemacht werden. Sollten trotzdem noch Zersetzungsprodukte in das Volumen 57 gelangen, so werden diese rasch und sicher durch das eine, eine vergleichsweise grosse Menge Molekularsiebmaterial enthaltende Molekularsiebmaterialdepot 58 gebunden. Das Molekularsiebmaterialdepot 58 dient hier als statischer Filter. Die Zersetzungsprodukte können deshalb den Quarzzylinder 34 und die optische Glasfaser nicht angreifen und den faseroptischen Sensor 33 negativ beeinflussen.

Die hier beschriebene Messeinrichtung kann sowohl in einphasig als auch in mehrphasig metallgekapselten gasisolierten Schaltanlagen eingesetzt werden. Bei mehrphasig metallgekapselten gasisolierten Schaltanlagen wird in der Regel jede der Phasen mit einer separaten Messeinrichtung ausgerüstet. Die vergleichsweise vorteilhaft kleinen Abmessungen der Messeinrichtung wirken sich besonders vorteilhaft aus, wenn beispielsweise eine dreiphasig metallgekapselte gasisolierte Schaltanlage mit Messeinrichtungen bestückt wird, da der Raumbedarf für diese Schaltanlage durch diese Messeinrichtungen nur unwesentlich erhöht wird.

### BEZEICHNUNGSLISTE

- 20: Spannungsmesseinrichtung
- 21: Kapselung
- 22: Aktivteil
- 23: Volumen
- 24: Schirmelektrode
- 25: zentrale Achse
- 26: Bohrung
- 27: Kontaktfedern
- 28: unterer Endflansch
- 29: Isolierrohr
- 30: oberer Endflansch
- 31: Deckel
- 32: Gefäss
- 33: faseroptischer Sensor
- 34: Quarzzylinder
- 35: Bohrung
- 36: Kontaktfedern
- 37: Ring
- 38: Scheibe
- 39: Halterung
- 40: Volumen
- 41: Halterung
- 42: Bund
- 43: Bohrung
- 44: Kontaktfedern
- 45,46: Ring
- 47: Anschlag
- 48: Ring
- 49: Halteeinrichtung
- 50: Bohrung
- 51: Anschlag
- 52: Auflagefläche
- 53: Thermoelement
- 54: Anschlüsse
- 55: Bohrung
- 56: Patrone
- 57: Volumen
- 58: Molekularsiebmaterialdepot
- 59: Durchlass
- 60: Volumen
- 61: Bohrung

## Patentansprüche

1. Messeinrichtung für den Einsatz in isoliergasgefüllten, metallgekapselten gasisolierten Schaltanlagen, mit mindestens einem mit einer optischen Glasfaser versehenen, entlang einer zentralen Achse (25) erstreckten Quarzkörper als Sensor, dadurch gekennzeichnet,
- dass der Sensor in einem separaten Volumen (40) im Innern der Schaltanlage angeordnet ist, welches von einem unteren Endflansch (28) und einem oberen Endflansch (30) und einem mit diesen druckdicht verbundenen Isolierrohr (29) begrenzt wird,
- dass der untere Endflansch (28) elektrisch leitend mit einem mit Hochspannung beaufschlagten Aktivteil (22) der Schaltanlage und mit der unteren Stirnseite des Quarzkörpers verbunden ist, und
- dass der obere Endflansch (30) elektrisch leitend mit der geerdeten Kapselung (21) der Schaltanlage und mit der oberen Stirnseite des Quarzkörpers verbunden ist.

2. Messeinrichtung nach Anspruch 1, dadurch gekennzeichnet,
- dass als Quarzkörper ein Quarzzylinder (34) vorgesehen ist, welcher an der oberen Stirnseite mit einer ersten allseitig stoss- und schwingungsgedämpft gelagerten metallischen Halterung (41) versehen ist und welcher an der unteren Stirnseite mit einer zweiten stoss- und schwingungsgedämpft gelagerten metallischen Halterung (39) versehen ist.

3. Messeinrichtung nach Anspruch 2, dadurch gekennzeichnet,
- dass die erste Halterung (41) mit einem Bund (42) versehen ist, welcher zwischen zwei in axialer Richtung stoss- und schwingungsdämpfend wirkenden Ringen (46,48) gelagert ist,
- dass die zweite Halterung (39) sich in axialer Richtung gegen eine stoss- und schwingungsdämpfend wirkende Scheibe (38) abstützt, und
- dass für die Dämpfung der radialen Komponenten der Schwingungen mindestens eine der beiden jeweils in einer Bohrung (43,35) mit Spiel geführten Halterungen (39,41) mit einer in der jeweiligen Bohrung (43,35) angeordneten Kombination von Kontaktfedern (36,44) und mindestens einem dritten Ring (37,45) aus stoss- und schwingungsdämpfend wirkendem Material versehen ist.

4. Messeinrichtung nach Anspruch 1, dadurch gekennzeichnet,
- dass als Quarzkörper ein Quarzzylinder (34) vorgesehen ist, welcher an der oberen Stirnseite mit einer ersten allseitig stoss- und schwingungsgedämpft gelagerten metallischen Halterung (41) versehen ist und welcher an der unteren Stirnseite mit einer zweiten metallischen Halterung (39) versehen ist,
- dass die erste Halterung (41) mit einem Bund (42) versehen ist, welcher zwischen zwei in axialer Richtung stoss- und schwingungsdämpfend wirkenden Ringen (46,48) gelagert ist, wobei der erste Ring (46) und der zweite Ring (48) so ausgelegt sind, dass sie den Quarzzylinder (34) samt seinen Halterungen (39,41), unabhängig von der Einbaulage, allein in Position halten, und
- dass für die Dämpfung der radialen Komponenten der Schwingungen mindestens eine der beiden jeweils in einer Bohrung (43,35) mit Spiel geführten Halterungen (39,41) mit einer in der jeweiligen Bohrung (43,35) angeordneten Kombination von Kontaktfedern (36,44) und mindestens einem dritten Ring (37,45) aus stoss- und schwingungsdämpfend wirkendem Material versehen ist.

5. Messeinrichtung nach Anspruch 4, dadurch gekennzeichnet,
- dass als stoss- und schwingungsdämpfendes Material ein offenporiger Silikonschaumstoff vorgesehen ist.

6. Messeinrichtung nach Anspruch 1, dadurch gekennzeichnet,
- dass das separate Volumen (40) mit einem Volumen (23) im Innern der metallgekapselten gasisolierten Schaltanlage verbunden ist, und
- dass in dieser Verbindung Mittel, insbesondere Molekularsiebmaterial, vorgesehen sind, welche Zersetzungsprodukte des SF₆-Gases binden.

7. Messeinrichtung nach Anspruch 6, dadurch gekennzeichnet,
- dass das Molekularsiebmaterial verteilt ist auf mindestens einen dynamischen Filter und auf mindestens einen statischen Filter, wobei der dynamische Filter als durchströmte Patrone (56) und der statische Filter als Molekularsiebmaterialdepot (58) ausgebildet ist.

8. Messeinrichtung nach Anspruch 7, dadurch gekennzeichnet,
- dass als Molekularsiebmaterial ein Material entsprechend der Formel 0,7CaO·0,3Na₂O·Al₂O₃·2SiO₂·nH₂O verwendet wird.

9. Messeinrichtung nach Anspruch 1, dadurch gekennzeichnet,
- dass die Messeinrichtung als Spannungsmesseinrichtung (20) ausgelegt ist.

10. Messeinrichtung nach Anspruch 9, dadurch gekennzeichnet,
- dass die Messeinrichtung mit einer Temperaturkompensation versehen ist, wobei für die Temperaturmessung ein Thermoelement vorgesehen ist, welches in der kapselungsseitigen Halterung (41) in unmittelbarer Nähe der oberen Stirnfläche des Quarzzylinders (34) eingebaut ist.
